# EUROPÄISCHE PATENTSCHRIFT

(11) **EP 0 598 855 B1**
(45) Veröffentlichungstag und Bekanntmachung des Hinweises auf die Patenterteilung: **23.10.1996**
(21) Anmeldenummer: 92924467.1
(22) Anmeldetag: 26.05.1992
(51) Int. Cl.: H01S 3/25, H01S 3/10, H01L 27/15, H01S 3/085, G02F 3/00, H04J 14/02

(54) **OPTISCH STEUERBARER HALBLEITERLASER**
OPTICALLY CONTROLLED SEMICONDUCTOR LASER
LASER A SEMICONDUCTEUR A COMMANDE OPTIQUE

(30) Priorität: 31.05.1991 DE 4117865; 31.05.1991 DE 4117868
(43) Veröffentlichungstag der Anmeldung: 01.06.1994
(73) Patentinhaber: Alcatel SEL Aktiengesellschaft, D-70435 Stuttgart (DE); ALCATEL N.V., NL-1077 XX Amsterdam (NL)
(72) Erfinder: SCHILLING, Michael, D-7000 Stuttgart 31 (DE); IDLER, Wilfried, D-7144 Asperg (DE); BAUMS, Dieter, D-7140 Ludwigsburg (DE); LAUBE, Gert, D-7000 Stuttgart 40 (DE); WÜNSTEL, Klaus, D-7141 Schwieberdingen (DE); HILDEBRAND, Olaf, D-7000 Stuttgart (DE)
(74) Vertreter: Kugler, Hermann, Dipl.-Phys.
(86) Internationale Anmeldenummer: EP9201175
(87) Internationale Veröffentlichungsnummer: WO9222111

(56) Entgegenhaltungen:
- EP-A- 0 283 248
- US-A- 4 065 729
- PROCEEDINGS OF THE 16TH EUROPEAN CONFERENCE ON OPTICAL COMMUNICATION, SEPTEMBER 16-20, 1990 Bd. 1, AMSTERDAM, NL Seiten 479 - 482; W. IDLER ET AL.: 'High speed integrated interferometric injection laser with 22 nm tuning range'
- IEEE JOURNAL OF QUANTUM ELECTRONICS. Bd. 24, Nr. 11, November 1988, NEW YORK US pages 2153 - 2159; HITOSHI KAWAGUCHI ET AL:: 'Tunable optical-wavelenght conversion using an optically triggerable multielectrode distributed feedback laser diode'
- IEEE TRANSACTIONS PHOTONICS TECHNOLOGY LETTERS Bd. 3, Nr. 12, Dezember 1991, NEW YORK, US Seiten 1054 - 1057; M. SCHILLING ET AL.: 'Multifunctional photonic switching operation of 1500 nm Y-coupled cavity laser (YCCL) with 28 nm tuning capability'

## Beschreibung

Die Erfindung geht aus von einem Halbleiterlaser mit verzweigter Kavität.

Ein solcher Halbleiterlaser ist bekannt aus Electronics Letters, 15th February, 1990, Vol. 26, No. 4, Seiten 243 bis 244. Er ist auf einem n-dotierten Indiumphosphid-Substrat monolithisch integriert. Die untere Seite des Substrats wird als Grundfläche bezeichnet. Oberhalb einer zur Grundfläche koplanaren Ebene erstreckt sich eine Kavität aus Indium-Gallium-Arsenid-Phosphid (InGaAsP). Sie ist verzweigt und hat in der Draufsicht die Form eines "Y". Die Draufsicht-Fläche der Kavität kann auch eine andere Form, z.B. die Form eines Kreuzes, haben. Wesentlich ist, daß die Kavität zusammenhängend ist. Dies läßt sich im Sinne einer topologischen Definition so beschreiben, daß die Draufsicht-Fläche der Kavität als "einfach zusammenhängendes Gebiet" aufzufassen ist, da sie nicht aus mehreren Stücken, sondern aus einem einzigen Stück mit einem einzigen Rand besteht. Die Kavität liegt auf der ebenen Oberfläche einer n-dotierten Pufferschicht aus Indiumphosphid, die sich oberhalb des Indiumphosphid-Substrats erstreckt.

Oberhalb der Kavität sind weitere Schichten vorhanden. Diese und die Kavität bilden oberhalb der Pufferschicht eine Mesa, die durch Ätzen entstanden ist. Die Mesa hat in der zur Grundfläche koplanaren Ebene, ebenso wie die Kavität, eine Y-Form.

Ein solcher Laser mit verzweigter Kavität ist gemäß der oben genannten Veröffentlichung vorgesehen als elektrisch steuerbare Lichtquelle für optische Nachrichtenübertragungssysteme. Insbesondere, wenn seine oberhalb der Kavität verlaufende Metallschicht in mehrere Elektroden unterteilt ist, so daß es dadurch Bereiche der Kavität gibt, die durch unterschiedliche Betriebsströme steuerbar sind, zeichnet sich der Laser durch eine über einen sehr weiten Wellenlängenbereich reichende Abstimmbarkeit seiner Emissionswellenlänge aus. Diese Eigenschaft steht bei der vorgesehenen Anwendung als elektrisch steuerbare Lichtquelle im Vordergrund.

Es ist die Aufgabe der Erfindung, eine optische Einrichtung mit einem solchen Laser zu schaffen, bei der der Laser in einer anderen Funktion als in der einer elektrisch steuerbaren Lichtquelle verwendet ist. Außerdem ist es Aufgabe der Erfindung, Verwendungen der neuen optischen Einrichtung anzugeben. Die Aufgabe wird mit den in Patentanspruch 1 oder Patentanspruch 2 angegebenen Merkmalen gelöst. Verwendungen sind in den Ansprüchen 5, 6, 8, 10, 11, 12 und 13 angegeben.

Dabei ist es bei unverzweigten Halbleiterlaser-Bauelementen bekannt, mit Hilfe von Einstrahlung optischer Leistung bestimmter Wellenlänge zwischen zwei Resonanzfrequenzen umzuschalten. Siehe hierzu EP 0 283 248 A2 und JEEE Journal of Quantum Electronics 24 (1988) Nov., No. 11, New York, NY, USA, pp. 2153-2159.

Weiterbildungen der optischen Einrichtungen nach Anspruch 1 oder Anspruch 2, sind den auf diese Ansprüche direkt oder indirekt rückbezogenen Unteransprüchen zu entnehmen.

Nachstehend wird die Erfindung in einem Ausführungsbeispiel anhand der Zeichnungen näher erläutert. Es zeigen:
- Fig. 1: ein erstes Ausführungsbeispiel der erfindungsgemäßen optischen Einrichtung,
- Fig. 2: die Wellenlänge des von dem Halbleiterlaser 1 aus Fig. 1 emittierten Lichts als Funktion der optischen Leistung P_{E} des in ihn eingestrahlten Lichts,
- Fig. 3a: die optische Leistung P_{E} eines verrauschten Lichtsignals als Funktion der Zeit, das in den Halbleiterlaser 1 aus Fig. 1 eingestrahlt wird,
- Fig. 3b: die Wellenlänge des Ausgangs-Lichtsignals des ersten Halbleiterlasers als Funktion der Zeit bei Einstrahlung eines Lichtsignals nach Fig. 3a,
- Fig. 3c: den zeitlichen Verlauf der optischen Leistung P_{A} des Ausgangs-Lichtsignals des Halbleiterlasers nach Durchlaufen eines wellenlängenselektiven optischen Filters bei Einstrahlen eines Lichtsignals nach Fig. 3a,
- Fig. 4a: die optische Leistung P_{E} eines Lichtsignals als Funktion der Zeit, das in den Halbleiterlaser eingestrahlt wird und einen Gleichlichtanteil enthält,
- Fig. 4b: den zeitlichen Verlauf der optischen Leistung P_{A} des Ausgangs-Lichtsignals des ersten Halbleiterlasers nach Durchlaufen eines wellenlängenselektiven optischen Filters bei Einstrahlung eines Lichtsignals nach Fig. 4a,
- Fig. 5: ein zweites Ausführungsbeispiel der erfindungsgemäßen optischen Einrichtung,
- Fig. 6: die optische Leistung P_{A} (λ₂) des von dem Halbleiterlaser 1 aus Fig. 5 ausgestrahlten Lichts als Funktion des Betriebsstroms I für verschiedene optische Leistungen des eingestrahlten Lichts,
- Fig. 7A: die optische Leistung P_{E} (λ₂) eines verrauschten Lichtsignals als Funktion der Zeit, das in den Halbleiterlaser 1 aus Fig. 5 eingestrahlt wird, und
- Fig. 7B: die optische Leistung P_{A} (λ₁) des aus dem ersten Halbleiterlaser emittierten Lichtsignals als Funktion der Zeit bei Einstrahlung eines Lichtsignals nach Fig. 7A.

In der folgenden Beschreibung wird für optische Strahlung irgendeiner Wellenlänge aus Gründen der Vereinfachung der Ausdruck "Licht" und für "optisches Signal" der Ausdruck "Lichtsignal" verwendet, auch wenn in den meisten Fällen die Wellenlänge der optischen Strahlung oder des optischen Signals außerhalb des sichtbaren Bereichs liegt.

Auch wird bisweilen statt des Ausdrucks "Halbleiterlaser" einfach der Ausdruck "Laser" verwendet.

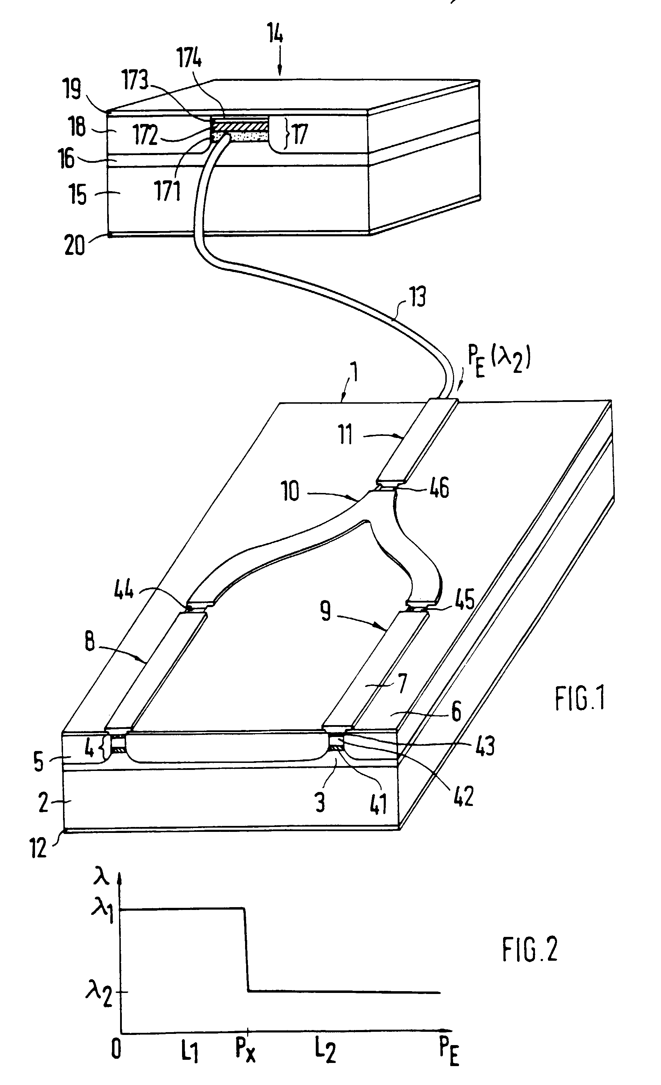

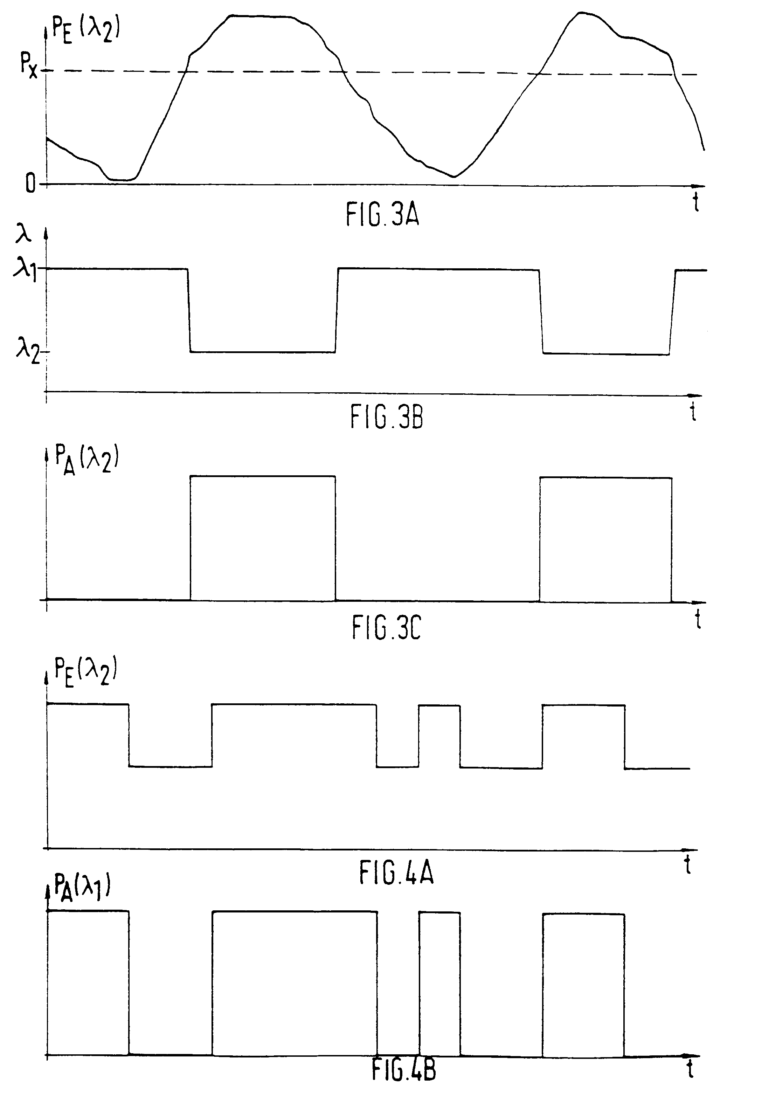

In Fig. 1 ist ein erster Halbleiterlaser 1 dargestellt. Er hat ein Substrat 2 aus n-dotiertem Indiumphosphid. Darüber liegt eine Pufferschicht 3, die ebenfalls aus n-dotiertem Indiumphosphid besteht und von der ein Teil die unterste Schicht einer Mesa 4 bildet, die in der Draufsicht die Form eines Y hat. Die Mesa 4 hat mehrere Schichten. Sie enthält eine Kavität 41 aus Indium-Gallium-Arsenid-Phosphid. Diese wird von einer Mantelschicht 42 aus p-dotiertem Indiumphosphid bedeckt. Darüber liegt eine Kontaktschicht 43 aus p⁺-dotiertem Indium-Gallium-Arsenid. Seitlich der Mesa 4 und oberhalb der nicht durch die Schicht 41 bedeckten Oberfläche der Pufferschicht 3 ist zur elektrischen Isolation und zur optischen Wellenführung in der Mesa 4 eine Schicht aus semiisolierendem Indiumphosphid vorhanden, deren obere Oberfläche mit der oberen Oberfläche der Kontaktschicht 43 eine Ebene bildet. Die Schicht 5 ist mit einer Schutzschicht 6 aus Siliziumdioxid bedeckt, die Kontaktschicht 43 mit einer Metallschicht 7. In die Metallschicht 7 und die Mesa 4 sind drei Gräben 44, 45, 46 hineingeätzt, durch die der Laser in vier Bereiche 8, 9, 10 und 11 eingeteilt ist. Gemäß der Darstellung in Fig. 1 können die Gräben 44, 45, 46 entsprechend der optischen Kopplung, die die Bereiche 8 bis 11 untereinander haben sollen, auch bis in die Mantelschicht 42, jedoch nicht bis in die Kavität 41 hinabreichen. Die Metallschicht 7 bildet in jedem Bereich 8 bis 11 eine erste Elektrode. Eine zweite Elektrode wird für jeden Bereich 8 bis 11 durch eine Metallschicht 12 gebildet, die unterhalb des Substrats 2 aufgebracht ist. Von der Metallschicht 7 jedes der Bereiche 8 bis 11 fließt beim Betrieb des Halbleiterlasers 1 durch den jeweiligen Bereich 8 bis 11 ein jeweils einzeln fest einstellbarer oder veränderbarer Strom zu der Metallschicht 12, die als Massekontakt dient.

Die Kavität 41 kann in ihrem Querschnitt eine Quantum-Well-Schichtstruktur haben, wie sie z.B. aus Appl. Phys. Let. 39 (1981), S. 786 bis 788 bekannt ist. Sie kann aber auch eine andere Schichtstruktur haben. Für die Erfindung spielt dies keine Rolle.

Der Halbleiterlaser 1 emittiert, wenn seine Kavität 41 die Zusammensetzung In_{0,62} Ga_{0,38} As_{0,82} P_{0,18} hat, Licht im Wellenlängenbereich um 1520 nm.

Hat die Kavität 41 eine Zusammensetzung In_{o,57} Ga_{0,43} As_{0,73} P_{0,27}, so emittiert er Licht im Wellenlängenbereich um 1300 nm. In beiden Fällen ist der Wellenlängenbereich durch Verändern der Betriebsströme um mindestens ±20 nm durchstimmbar.

Der Halbleiterlaser 1 kann auch als GaAlAs/GaAs-Halbleiterlaser aufgebaut sein; ein derartiger Aufbau ist z.B. aus Appl. Phys. Lett., 52 (1988), S. 767 bis 769 bekannt.

Die Mesa 4 und damit die Kavität 41 läßt sich nicht nur, wie in Fig. 1 dargestellt, in Form eines "Y" aufbauen, sondern beispielsweise auch in Kreuzform, wie sie dieser Veröffentlichung ebenfalls zu entnehmen ist.

Zur erfindungsgemäßen optischen Einrichtung gehört neben dem Laser 1 auch eine nicht gezeigte Laser-Steuerschaltung, die den Betriebsstrom für den Laser, oder, falls er mehrere Bereiche hat, die Betriebsströme, liefert. Wird diese Steuerschaltung eingeschaltet, so versorgt sie den Laser derart mit Betriebsstrom (oder mehreren Betriebsströmen), daß er als Laser aktiv wird und kohärentes Licht aussendet.

Hat er mehrere Bereiche, so ist dies der Fall, wenn wenigstens durch einen der Bereiche 8 bis 11 ein Strom fließt, der oberhalb des Laser-Schwellenstroms liegt, so daß durch die Verbindung der Bereiche 8 bis 11 untereinander bewirkt wird, daß auch aus den übrigen Bereichen 8 bis 11 Licht aus dem Halbleiterlaser 1 ausgestrahlt wird. Im Falle des hier dargestellten Halbleiterlasers 1 liegt der Laser-Schwellenstrom für jeden einzelnen Bereich 8, 9, 10, 11 beispielsweise bei 30 mA.

Die Wellenlänge λ₁ des ausgesendeten kohärenten Lichts ist dann wie üblich bestimmt durch den Aufbau des Lasers und die Einstellung seines Betriebsstroms (oder seiner Betriebsströme).

Erfindungsgemäß unterliegt der Laser 1 nicht nur einer solchen elektrischen Ansteuerung, sondern auch einer optischen Ansteuerung. Es wird aus einer Lichtquelle Licht einer geeigneten Wellenlänge λ₂ in die Kavität des Lasers 1 eingestrahlt.

Die in Fig. 1 gezeigte Lichtquelle ist ein zweiter Halbleiterlaser 14, dessen erzeugtes Licht über einen Lichtwellenleiter 13 in den Halbleiterlaser 1 eingestrahlt wird. Einzelheiten eines geeigneten Lasers 14 werden an späterer Stelle erläutert.

In Abhängigkeit von der optischen Leistung P_{E} des von der Lichtquelle 14 in den Halbleiterlaser 1 eingestrahlten Lichts emittiert dieser entweder Licht mit einer Wellenlänge λ₁ oder Licht mit einer Wellenlänge λ₂. Dabei ist λ₁ die durch die Zusammensetzung des Lasers 1 und seine Abstimmung (durch Betriebsströme) vorgegebene Wellenlänge und λ₂ die Wellenlänge des in den Laser 1 eingestrahlten Lichts.

Welche Wellenlänge das Licht hat, das der Laser in seinem aktiven Zustand aussendet, ist also steuerbar durch die optische Leistung des eingestrahlten Lichts. In anderen Worten: Es handelt sich um eine optische Einrichtung mit einem Laser, der hinsichtlich seiner Emissionswellenlänge durch ein optisches Steuersignal umschaltbar ist.

Eingestrahlt werden kann das den Laser 1 steuernde Lichtsignal in den Bereich 11 des Lasers 1. Dann emittiert er je nach optischer Leistung des eingestrahlten Lichtsignals Licht entweder mit der Wellenlänge λ₁ oder mit der Wellenlänge λ₂. In gleicher Weise läßt sich das den Laser 1 steuernde Lichtsignal auch in den Bereich 8 oder 9 einstrahlen. Entsprechend emittiert dann der Laser 1 aus den Bereichen 9 und 11 bzw. 8 und 11 Licht mit der ersten oder der zweiten Wellenlänge.

Voraussetzung für die Umschaltbarkeit der Emissionswellenlänge ist, daß die Wellenlänge λ₂ des eingestrahlten Lichts nicht zu sehr, beispielsweise nicht mehr als 30 nm, von der Wellenlänge λ₁ abweicht. Genauer gesagt, muß λ₂ innerhalb des Durchstimmbereichs des Lasers, der z.B. von 1520 bis 1560 nm reicht, liegen.

In Fig. 2 ist die Wellenlänge des aus dem Halbleiterlaser 1 emittierten Lichts in Abhängigkeit von der optischen Leistung P_{E} des in ihn eingestrahlten Lichts dargestellt. Es lassen sich zwei Leistungsbereiche voneinander unterscheiden. Liegt P_{E} innerhalb eines bei Null beginnenden Leistungsbereichs L₁, so emittiert der Laser 1 Licht mit der (wie oben erläuterten) ersten Wellenlänge λ₁. Liegt P_{E} oberhalb des Leistungsbereichs L₁, also in einem Leistungsbereich L₂, so emittiert der Laser 1 Licht mit der zweiten Wellenlänge λ₂, die gleich der des eingestrahlten Lichts ist. Die optische Leistung, bei der der Leistungsbereich L₁ an den Leistungsbereich L₂ grenzt, ist mit Pₓ bezeichnet.

Ist, wie in Fig. 2 gezeigt, die erste Wellenlänge λ₁ die längere, so wird der Wechsel von der zweiten (kürzeren) Wellenlänge zu der ersten (längeren) Wellenlänge wegen der mit der kürzeren Wellenlänge einhergehenden höheren Frequenz und Energie als Abwärts-Konversion bezeichnet. Die erste Wellenlänge ist z.B. 1523 nm, die zweite Wellenlänge 1517 nm. Auch eine Aufwärts-Koversion läßt sich mit dem Laser 1 erreichen. In diesem Falle ist die erste Wellenlänge z.B. 1514 nm und die zweite Wellenlänge (die des eingestrahlten Lichts) wiederum 1517 nm.

Aufgrund des sprungartigen Wechsels der Emissionswellenlänge des Lasers 1 an der Grenze zwischen den Leistungsbereichen L₁ und L₂ läßt sich der Laser 1 z.B. zur Formung von optischen Rechteckimpulsen verwenden, die während der Übertragung über den Lichtwellenleiter 13 infolge der Dispersion verformt worden sind. Dies ist insbesondere dann der Fall, wenn der Lichtwellenleiter 13 eine große Länge hat. Die Lichtquelle der erfindungsgemäßen optischen Einrichtung ist dann weit entfernt von deren Halbleiterlaser angeordnet und sendet ein rechteckförmig intensitätsmoduliertes optisches Signal, das nach Übertragung über einen langen Lichtwellenleiter regeneriert werden muß.

Der Halbleiterlaser 1 wird z.B., wenn sein optisches Eingangssignal vom Leistungsbereich L₁ in den Leistungsbereich L₂ übergeht, gemäß Fig. 2 zur Emission einer kürzeren Wellenlänge wechseln. Damit werden digitale oder analoge Lichtsignale, die in den Halbleiterlaser 1 eingestrahlt werden, entsprechend ihrer optischen Leistung P_{E} in Lichtsignale einer ersten oder zweiten Wellenlänge umgewandelt.

Wenn in den Halbleiterlaser 1 aus dem Halbleiterlaser 14 ein aus "verschmierten" Rechteckimpulsen bestehendes Lichtsignal eingestrahlt wird, wie es in Fig. 3a als Funktion der Zeit dargestellt ist (optische Leistung P_{E}, Wellenlänge: λ₂), so wechselt die Emissionswellenlänge des Halbleiterlasers 1 zwischen den Wellenlängen λ₁ und λ₂. Sie ist in Fig. 3b als Funktion der Zeit dargestellt. Wie in Fig. 2 dargestellt, ergibt eine optische Leistung P_{E} des optischen Eingangssignals (mit der Wellenlänge λ₂) unterhalb von Pₓ die Wellenlänge λ₁ und eine optische Leistung P_{E} oberhalb von Pₓ die Wellenlänge λ₂.

Das von dem Laser 1 ausgestrahlte Lichtsignal mit den wechselnden Wellenlängen λ₁ und λ₂ läßt sich entweder zu einer anderen optischen Einrichtung übertragen, oder es wird in einem wellenlängenselektiven Filter, z.B. in einem Fabry-Pérot-Filter, gefiltert. Ist dieses nur für die Wellenlänge λ₂ durchlässig, so werden die ursprünglichen, durch die optische Übertragung verzerrten Rechteckimpulse wieder hergestellt. Dies zeigt Fig. 3c mit dem zeitlichen Verlauf der Leistung P_{A} des optischen Ausgangssignals (Wellenlänge λ₂) des optischen Filters.

Ist das wellenlängenselektive Filter hingegen für die Wellenlänge λ₁ durchlässig, so wird das Lichtsignal bei der Rechteckformung aus seiner ursprünglichen Wellenlänge λ₂ in die Wellenlänge λ₁ konvertiert und gleichzeitig invertiert.

Der Halbleiterlaser 1 stellt nicht nur die Flanken von Rechteckimpulsen wieder her. Er korrigiert auch Leistungsschwankungen des aus dem Halbleiterlaser 14 kommenden Lichts, soweit sich die Leistungsschwankungen jeweils innerhalb eines der Leistungsbereiche L₁ und L₂ bewegen.

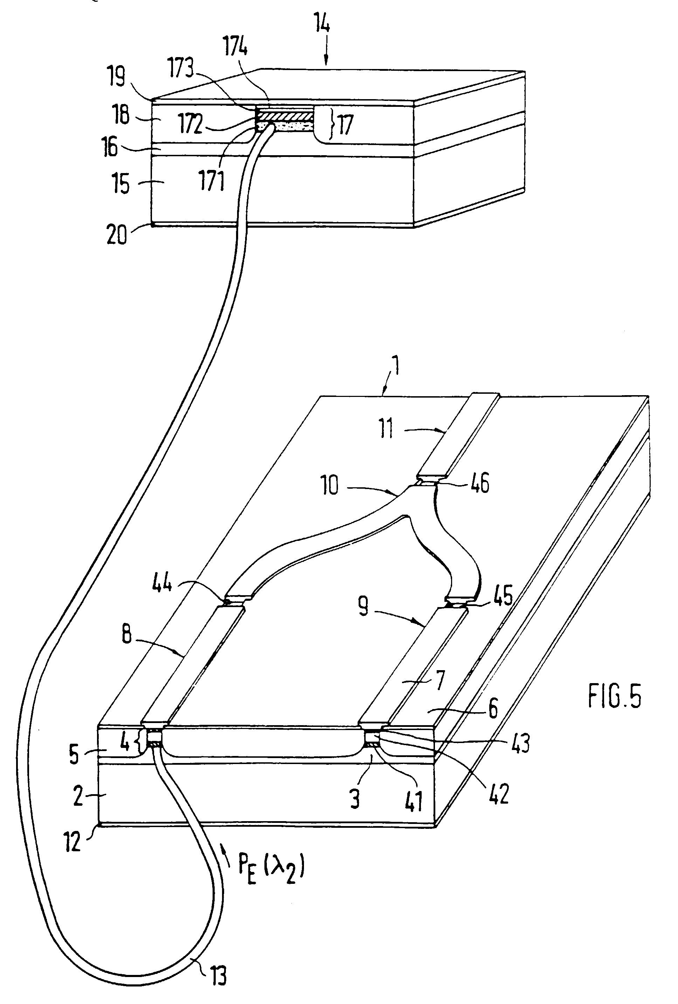

Eine weitere Funktion der optischen Einrichtung einschließlich eines optischen Filters besteht darin, den Gleichlichtanteil zu entfernen, wenn ein solcher, wie in Fig. 4a dargestellt, in dem zu übertragenden Lichtsignal enthalten ist. Wenn sich die optische Leistung P_{E} der Lichtimpulse beispielsweise in dem Leistungsbereich L₂ und die des Gleichlichtanteils in dem Leistungsbereich L₁ bewegt, wird aus dem Lichtsignal, das in den Halbleiterlaser 1 eingestrahlt wird, ein Lichtsignal erzeugt, das in den Zeitabschnitten, die den Lichtimpulsen des eingestrahlten Lichtsignals entsprechen, die Wellenlänge λ₁ und ansonsten die Wellenlänge λ₂ hat.

Wenn das Lichtsignal mit den abwechselnden Wellenlängen λ₁, λ₂ noch ein optisches Filter durchläuft, das nur für die Wellenlänge λ₁ durchlässig ist, so ist der Gleichlichtanteil des in den Halbleiterlaser 1 eingestrahlten Lichtsignals unterdrückt, was in Fig. 4b durch den zeitlichen Verlauf der optischen Leistung P_{A} des Ausgangs-Lichtsignals mit der Wellenlänge λ₁ eines solchen optischen Filters gezeigt ist.

Die anhand der Figuren 3 und 4 beschriebenen Anwendungen nutzen die Abwärts-Konversion in dem Halbleiterlaser 1. In entsprechender Weise läßt sich die Aufwärts-Konversion ausnutzen.

Wie schon die wenigen bisher erläuterten Ausführungsbeispiele zeigen, gestattet die hier beschriebene neue optische Einrichtung, insbesondere, wenn sie ein wellenlängenselektives optisches Filter enthält, eine Fülle von Anwendungen für die optische Übertragung.

Ein großer Vorteil, der sich ergibt, wenn man mit der neuen optischen Einrichtung ein Eingangs-Lichtsignal in ein Ausgangs-Lichtsignal umsetzt, besteht darin, daß das vom Laser 1 ausgestrahlte Lichtsignal gegenüber dem eingestrahlten Lichtsignal eine erheblich höhere Intensität haben kann. Unter dem Gesichtspunkt der optischen Signalübertragung hat der Laser 1 also die Funktion einer erheblichen Signalverstärkung, di in der Größenordnung von 20 dB liegt.

Im folgenden wird ein Ausführungsbeispiel eines als Lichtquelle 14 verwendbaren Halbleiterlasers anhand von Fig. 1 erläutert. Wie Fig. 1 zeigt, ist eine Lichtquelle 14, ein Halbleiterlaser, über einen Lichtwellenleiter 13 mit dem Lichtwellenleiter 13 mit dem Halbleiterlaser 1 verbunden, so daß Licht aus dem Laser 14 in den Laser 1 einstrahlbar ist. Um zu verhindern, daß Licht aus dem Laser 1 in den Laser 14 gelangt, ist ein hier nicht dargestellter optischer Isolator vorgesehen. Der Halbleiterlaser 14 ist beispielsweise ein Halbleiterlaser mit verteilter Rückkopplung (DFB-Halbleiterlaser).

Er ist auf einem Substrat 15 aus Indiumphosphid aufgebaut. Oberhalb des Substrats 15 ist eine Pufferschicht 16 aus Indiumphosphid aufgebracht, die die Basis einer Mesa 17 bildet. Die Mesa 17 enthält eine Wellenleiterschicht 171 aus n-dotiertem Indium-Gallium-Arsenid-Phosphid, eine nicht-dotierte Kavität 172 aus Indium-Gallium-Arsenid-Phosphid und eine Mantelschicht 173 aus p-dotiertem Indiumphosphid. Darüber liegt eine p⁺-dotierte Indium-Gallium-Arsenid-Schicht 174. Die Wellenleiterschicht 171 bildet in Längsrichtung mit der Pufferschicht 16 ein optisches Gitter. Seitlich der Mesa 17 und oberhalb der oberen Oberfläche der Pufferschicht 16, soweit sie nicht von der Mesa 17 bedeckt wird, ist eine Schicht 18 aus semiisolierendem Indiumphosphid vorhanden, deren obere Oberfläche mit der oberen Oberfläche der Mantel schicht 173 eine Ebene bildet. Darüber sowie unterhalb des Substrats 15 ist jeweils eine metallische Schicht 19 bzw. 20 vorhanden; die metallischen Schichten 19 und 20 dienen als Elektroden. Aus der Wellenleiterschicht 171 wird, wenn durch den Halbleiterlaser 14 ein Strom fließt, der größer als der Laser-Schwellenstrom ist, Laserlicht in den den Lichtwellenleiter 13 eingespeist, das in die Kavität 41 des Halbleiterlasers 1 eingespeist wird. In Abhängigkeit von der Stärke des Stroms, der durch den Halbleiterlaser 14 fließt, wird Licht unterschiedlicher optischer Leistung P_{E} in den Halbleiterlaser 1 eingestrahlt.

Anstelle des hier beschriebenen Halbleiterlasers 14 kann jede andere Lichtquelle vorgesehen werden, die Licht mit der geeigneten Wellenlänge, wie sie oben erläutert ist, aussendet und deren optische Leistung P_{E} veränderbar ist. Auch andere Halbleiterlaser kommen hierfür in Frage. Anstelle des die Halbleiterlaser 1 und 14 verbindenden Lichtwellenleiters 13 sind auch andere Mittel zur optischen Übertragung zwischen der Lichtquelle und dem Halbleiterlaser 1 einsetzbar. Die Übertragung kann auch über eine Luftstrecke geschehen.

Zur Fokussierung des aus der Lichtquelle kommenden Lichts auf den Halbleiterlaser 1 sind Linsen einsetzbar; insbesondere eignet sich bei Einsatz des Lichtwellenleiters 13 Schmelzlinsen an den Enden des Lichtwellenleiters 13.

Ein Halbleiterlaser, der wie der Halbleiterlaser 14 auf dem gleichen Substratmaterial aufgebaut ist wie der Halbleiterlaser 1 - in dem hier beschriebenen Ausführungsbeispiel: Indiumphosphid - läßt sich mit diesem auf einem einzigen Substrat monolithisch integrieren. In einem solchen Fall erübrigt sich ein Lichtwellenleiter. Es genügt eine einzige, in einem die Halbleiterlaser voneinander trennenden Graben aufgeklebte Linse, um die Fokussierung des Lichts aus dem Halbleiterlaser, der dem Halbleiterlaser 14 entspricht, in den anderen Halbleiterlaser zu bewirken, der dem Halbleiterlaser 1 entspricht.

Im folgenden werden anhand der Figuren 5 bis 7 ein zweites Ausführungsbeispiel der erfindungsgemäßen optischen Einrichtung und Beispiele für deren Verwendungen erläutert. Das Ausführungsbeispiel nach Fig. 5 unterscheidet sich von dem nach Fig. 1 nur dadurch, daß der die Lichtquelle 14 mit dem Halbleiterlaser 1 verbindende Lichtwellenleiter 13 nicht wie beim Ausführungsbeispiel nach Fig. 1 das Licht in den Bereich 11 des Halbleiterlasers, sondern in einen der Bereiche 8 und 9 einstrahlt. Dies ist für das Prinzip der Erfindung jedoch nicht wesentlich, sondern nur für einige von nachstehend beschriebenen Ausführungsbeispielen die bevorzugte Ausführungsform.

Wesentlich für die folgenden Ausführungsbeispiele der Erfindung ist, daß die zur optischen Einrichtung gehörende nicht gezeigte Laser-Steuerschaltung den Laser 1 derart mit Betriebsstrom (oder mit mehreren Betriebsströmen) versorgt, daß er dadurch noch nicht im laseraktiven Zustand ist, bei dem er kohärentes Licht aussenden würde. Falls der Laser wie gezeigt und oben erläutert mehrere Bereiche hat, die getrennt durch Betriebsströme ansteuerbar sind, so kann dieser Zustand durch eine geeignete Kombination von Betriebsströmen eingestellt werden. Falls der Laser nicht in mehrere Bereiche unterteilt ist, so kann dieser Zustand durch den einzigen Betriebsstrom eingestellt werden.

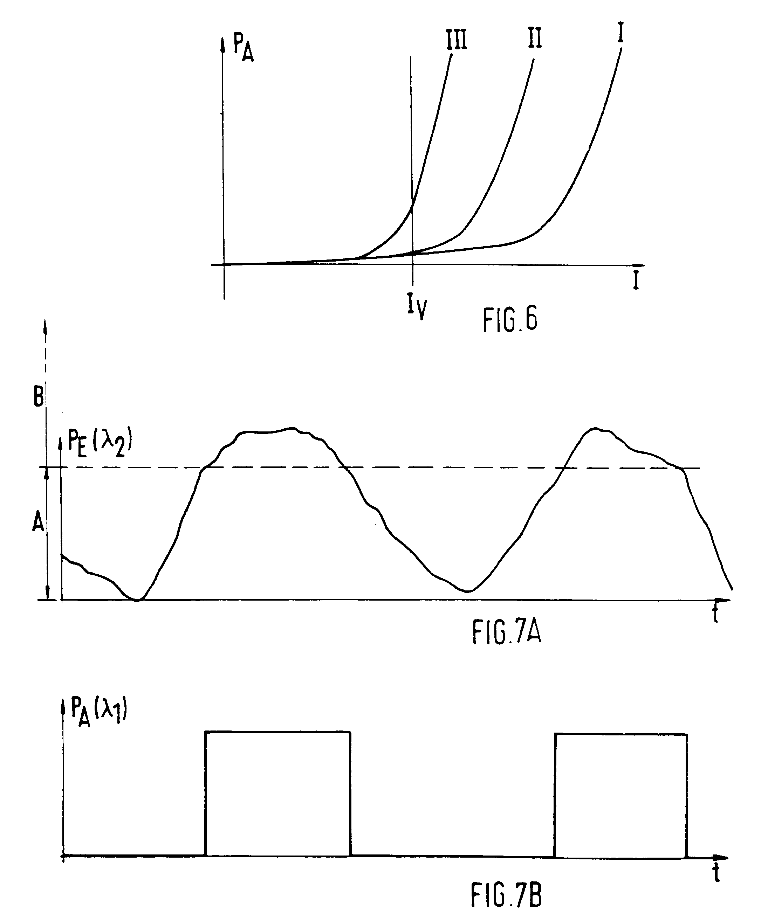

Erfindungsgemäß unterliegt der Laser 1 nicht nur einer solchen elektrischen Ansteuerung, sondern auch einer optischen Ansteuerung durch Licht aus der Lichtquelle 14. Was eine solche optische Ansteuerung bewirkt, wird nun anhand von Fig. 6 erläutert. Diese zeigt die optische Leistung P_{A} des aus dem Laser 1 ausgestrahlten Lichts in Abhängigkeit von dem Betriebsstrom des Lasers für verschiedene optische Leistungen des in den Laser 1 eingestrahlten Lichts. Ohne Einstrahlung von Licht in einen der Bereiche 8 und 9 verläuft P_{A} über I gemäß der Kurve I. Derjenige Betriebsstrom, bei dem die Kurve beginnt, steil anzusteigen, ist beträchtlich hoch. Es ist der sogenannte Laser-Schwellenstrom. Solange der Betriebsstrom darunter liegt, wird Licht, das im Bereich 11 erzeugt ist, absorbiert, und es kommt nicht zum Aussenden von kohärentem Licht. Erst oberhalb des Laser-Schwellenstroms beginnt die Laseraktivität, d.h. die Aussendung von kohärentem Licht. Mit zunehmender Einstrahlung von Licht in die Bereiche 8 und 9 wird die Absorption mehr und mehr kompensiert, so daß der Laserbetrieb bereits bei einem niedrigeren Betriebsstrom einsetzt. Liegt der Betriebsstrom I bei I_{V}, so ist der Laser im Falle der fehlenden Einstrahlung von Licht (Kurve I) nicht im laseraktiven Zustand. Wird allerdings Licht mit einer ausreichend hohen optischen Leistung in ihn eingestrahlt, so verläuft P_{A} über den Betriebsstrom I gemäß Kurve III, so daß bei dem gewählten Betriebsstrom I_{V} bereits der Laserbetrieb stattfindet.

In anderen Worten: Durch Licht geeigneter Wellenlänge und ausreichend hoher optischer Leistung ist der Laser in den Laserzustand schaltbar. Es handelt sich also hierbei um einen durch optische Steuerung ein- und ausschaltbaren Laser. Ist der Laser als Laser aktiv, d.h. durch eingestrahltes Licht in diesen Zustand geschaltet, so emittiert er Licht mit einer Wellenlänge λ₁, die wie üblich bestimmt ist durch den Aufbau des Lasers und die Einstellung seines Betriebsstroms (oder seiner Betriebsströme).

Die Wellenlänge des eingestrahlten Lichts, die mit λ₂ bezeichnet sei, muß kleiner sein als eine maximale Wellenlänge, die der Energie des Bandabstandes im Lasermaterial entspricht. Darunter kann sie beliebige Werte annehmen, so daß die Wellenlänge λ₂ des eingestrahlten Lichts jedenfalls kürzer ist als die Wellenlänge λ₁ des emittierten Lichts.

Die Anregung des Lasers 1 zur Emission von Licht einer Wellenlänge λ₁ durch Einstrahlen von Licht einer Wellenlänge λ₂, wobei λ₂ kürzer als λ₁ ist, ist vergleichbar mit der Photolumineszenz, die für Halbleiterkristalle an sich bekannt ist (S.M.Sze, Physics of Semiconductor Devices; New York, Chichester, Brisbane, Toronto 1981). Dort tritt als Folge einer Photoneninjektion Photolumineszenz auf.

Was die Steuerung des Lasers 1 durch das eingestrahlte Licht betrifft, so lassen sich zwei Bereiche der optischen Eingangsleistung des eingestrahlten Lichts unterscheiden: ein erster Leistungsbereich A, und ein zweiter Leistungsbereich B, der oberhalb des ersten Leistungsbereichs liegt. Liegt die optische Leistung des eingestrahlten Lichts im ersten Leistungsbereich, so wird kein kohärentes Licht aus dem Laser emittiert, liegt sie im zweiten Leistungsbereich, so wird kohärentes Licht der Wellenlänge λ₁ aus dem Laser emittiert.

Da das Verhalten des Lasers 1 an der Grenze zwischen den Leistungsbereichen A und B sich sprungartig verändert, läßt sich der Halbleiterlaser 1 zur Formung von optischen Rechteckimpulsen verwenden, die während der Übertragung durch den Lichtwellenleiter 13 infolge der Dispersion verformt worden sind. Dies ist insbesondere dann der Fall, wenn der Lichtwellenleiter 13 eine große Länge hat. Die Lichtquelle der erfindungsgemäßen optischen Einrichtung ist dann weit entfernt von deren Halbleiterlaser 1 angeordnet und sendet ein rechteckförmig intensitätsmoduliertes Lichtsignal, das nach Übertragen über einen langen Lichtwellenleiter regeneriert werden muß. Die erfindungsgemäße optische Einrichtung, bestehend aus Lichtquelle, Übertragungs-Lichtwellenleiter 13, Laser 1 und dazugehöriger Steuerschaltung ist dann also ein optisches Nachrichtenübertragungssystem.

Wenn das Lichtsignal, das in den Halbleiterlaser 1 eingestrahlt wird, digital moduliert ist und seine Maxima eine optische Leistung P_{E} haben, die oberhalb der Grenze zwischen den Leistungsbereichen A und B, also im Leistungsbereich B, liegt, so wird es durch den Laser 1 in seiner Wellenlänge umgewandelt. Außerdem läßt sich seine ursprüngliche Form wiedergewinnen, wie anschließend erläutert wird. Durch das eingestrahlte Lichtsignal mit der Wellenlänge λ₂ wird der Laser 1 im Rhythmus seiner ansteigenden und abfallenden Flanken ein- bzw. ausgeschaltet, wobei er im eingeschalteten Zustand Licht mit der Wellenlänge λ₁ emittiert. Wie oben erläutert, kann die Wellenlänge λ₂ weit unterhalb der Emissionswellenlänge λ₁ des Lasers 1 liegen. Somit ist also eine Wellenlängenkonversion über einen Wellenlängenbereich von mehreren 100 Nanometern möglich.

Insbesondere die Konversion von digital intensitätsmoduliertem Licht mit einer Wellenlänge aus dem Wellenlängenbereich um 850 nm in Licht mit einer Wellenlänge aus dem Wellenlängenbereich um 1550 nm ist vorteilhaft für die optische Nachrichtenübertragung: Mehrere kostengünstige GaAlAs/GaAs-Halbleiterlaser erzeugen als Sendelaser Lichtsignale mit der Wellenlänge 850 nm. Diese werden über kurze Reichweiten zu einem optischen Multiplexer übertragen und dort zu einem optischen Multiplexsignal gebündelt. Der Halbleiterlaser 1 der erfindungsgemäßen optischen Einrichtung konvertiert es dann in ein Multiplexsignal mit der Wellenlänge 1550 nm, die für die Übertragung über Lichtwellenleiter mit großer Länge geeigneter ist als die Wellenlänge von 850 nm, weil die Dämpfung in ihnen wesentlich weniger stark ist. Die Sendelaser können auch InGaAsP/InP-Halbleiterlaser sein, die Licht im Wellenlängenbereich um 1300 nm emittieren, das dann im Laser 1 in Licht mit einer Wellenlänge um 1550 nm umgesetzt wird.

Die Veränderung eines digital intensitätsmodulierten optischen Signals hinsichtlich der Form und Wellenlänge seiner Impulse wird nun anhand der Figuren 7A und 7B erläutert. Wenn in den Laser 1 aus dem Laser 14 ein aus "verschmierten" Rechteckimpulsen bestehendes Lichtsignal mit einer Wellenlänge λ₂ und mit einem zeitlichen Verlauf seiner optischen Leistung, wie er in Fig. 7A dargestellt ist, eingestrahlt wird, so emittiert der Halbleiterlaser 1 wie folgt: Liegt die optische Eingangsleistung P_{E} oberhalb des Übergangs zwischen den Bereichen A und B, d.h. im Bereich B, so emittiert er kohärentes Licht mit der Wellenlänge λ₁, und er emittiert praktisch kein Licht, wenn P_{E} unterhalb des genannten Übergangs liegt. Die Grenze zwischen dem Leistungsbereich A und dem Leistungsbereich B der optischen Eingangsleistung P_{E} ist in Fig. 7A durch eine gestrichelte Linie angedeutet.

Fig. 7B zeigt den Verlauf der optischen Leistung P_{A} des bei Einstrahlung eines Lichtsignals nach Fig. 7A vom Laser 1 emittierten Lichtsignals mit der Wellenlänge λ₁. Wie man sieht, sind darin die ursprünglichen, durch die optische Übertragung verzerrten Rechteckimpulse wiederhergestellt. Außerdem ist das Lichtsignal aus seiner ursprünglichen Wellenlänge λ₂ in die Wellenlänge λ₁ konvertiert.

Auch bei den vorstehend beschriebenen Beispielen einer Verwendung der neuen optischen Einrichtung besteht der oben erwähnte Vorteil einer erheblichen Signalverstärkung.

Eine Anwendung der vorstehend beschriebenen optischen Einrichtung mit dem durch ein optisches Steuersignal einschaltbaren Laser als ODER- oder als UND-Schaltung wird im folgenden erläutert. Da der Halbleiterlaser 1 mindestens drei Enden seiner Kavität hat, in die Licht einstrahlbar oder aus denen Licht ausstrahlbar ist, ist es auch möglich, die optische Einrichtung derart zu gestalten, daß nicht nur eines, sondern zwei Steuersignale, jeweils eines aus einer eigenen Lichtquelle, in ihn eingestrahlt werden und an einem anderen Ende das vom Laser 1 erzeugte Licht emittiert wird.

Wenn sowohl über den Bereich 8 als auch über den Bereich 9 ein Lichtsignal in den Laser 1 eingestrahlt werden kann, z.B. aus weit entfernten Lichtquellen, und der Halbleiterlaser durch seinen Betriebsstrom oder seine Betriebsströme so betrieben ist, daß bereits die optische Leistung eines einzigen der beiden in ihn eingestrahlten Lichtsignale, das entweder über den Bereich 8 oder den Bereich 9 in den Laser 1 gelangt, ausreicht, um im Bereich 11 kohärentes Licht mit der Wellenlänge λ₁ zu erzeugen, so wirkt der Laser 1 als logische ODER-Schaltung. Dann erzeugt er immer ein Lichtsignal, wenn über den Bereich 8 oder ober den Bereich 9 oder gleichzeitig über die Bereich 8 und 9 ein Lichtsignal mit ausreichender Intensität in ihn hineingelangt. Auch hierbei ist vorausgesetzt, daß die Betriebsströme so gewählt sind, daß durch sie der Laserbetrieb und damit die Emission von kohärentem Licht noch nicht bewirkt wird.

Sind die Betriebsströme so bemessen, daß mit einem einzigen Lichtsignal mit vorgegebener Intensität, das in den Bereich 8 oder in den Bereich 9 eingestrahlt wird, sich der Laserbetrieb noch nicht ergibt, sondern erst durch Einstrahlung von zwei Lichtsignalen, eines in den Bereich 8 und eines in den Bereich 9, so wirkt der Laser 1 als logische UND-Schaltung. Die beiden Eingangslichtsignale müssen im Falle des Betriebs als ODER-Schaltung oder des Betriebs als UND-Schaltung nicht dieselbe Wellenlänge haben. Ihre Wellenlänge muß allerdings, wie oben erläutert, unterhalb einer maximalen Wellenlänge liegen. Auch muß der Halbleiterlaser in diesen Fällen nicht unbedingt so betrieben werden, daß an den Bereichen 8 und 9 die steuernden Lichtsignale eingestrahlt und am Bereich 11 das erzeugte Licht emittiert wird. Es können prinzipiell auch zwei andere der drei Enden der Kavität als Eingänge und das dann verbleibende dritte Ende der Kavität als optischer Ausgang verwendet werden.

Wird die vorstehend beschriebene neue optische Einrichtung mit zwei Eingangs-Lichtsignalen betrieben, so können auch andere Funktionen als die von logischen Schaltungen realisiert werden. Beispielsweise ist es möglich, zwei digital modulierte Eingangs-Lichtsignale zu einem Multiplex-Lichtsignal zusammenzufassen. Dies macht dann Sinn, wenn sich die Signale ausreichend voneinander unterscheiden, so daß ihre Informationen dem Multiplexsignal wieder entnehmbar sind.

In einem weiteren, in der Zeichnung nicht dargestellten Ausführungsbeispiel ist zwischen den Bereichen 8 und 9 einerseits sowie dem Verzweigungsbereich 10 andererseits je ein weiterer Bereich vorhanden, der als sättigbarer Absorber dient. In diesem Falle läßt sich der Halbleiterlaser 1 auch als optischer Speicher nutzen.

Durch Injektion von Photonen in die sättigbaren Absorber aus den Bereichen 8 und 9 werden in den Absorbern Ladungsträger erzeugt.

Dadurch wird in den Absorbern die Absorption reduziert, bis sie transparent geworden sind. Wenn aufgrund dessen Licht aus den Bereichen 8 und 9 in den Bereich 11 gelangt, wird dieser laseraktiv und erzeugt kohärentes Licht. Auch wenn die optische Leistung von in die Bereiche 8 und 9 eingestrahlten Lichtsignalen nun zurückgeht, bleibt die Transparenz der sättigbaren Absorber aufrechterhalten und somit die Erzeugung von kohärentem Licht in dem Bereich 11.

Die als sättigbare Absorber dienenden Bereiche können auch an anderen Stellen als zwischen den Bereichen 8 und 9 einerseits und dem Verzweigungsbereich andererseits angeordnet sein, z.B. zwischen anderen, aneinander angrenzenden Bereichen der Kavität oder an ihren Enden.

## Patentansprüche

1. Optische Einrichtung mit einem auf einem Substrat (2) monolithisch integrierten ersten Halbleiterlaser (1), der eine Kavität (41) mit einfach zusammenhängender Struktur besitzt, die sich oberhalb einer zur Grundfläche des Substrates (2) koplanaren Ebene erstreckt und verzweigt ist, und mit einer Lichtquelle (14) mit einstellbarer optischer Leistung (P_{E}), aus der in die Kavität (41) des ersten Halbleiterlasers (1) Licht einstrahlbar ist, durch welches die Wellenlänge von von dem ersten Halbleiterlaser ausgestrahlten kohärenten Lichtsignalen abhängig von der optischen Leistung des eingestrahlten Lichtes verändert werden kann, wobei das von der Lichtquelle (14) in den Halbleiterlaser (1) eingestrahlte Licht eine derartige Wellenlänge (λ₂) hat, daß in Abhängigkeit von seiner optischen Leistung (P_{E}) das vom Halbleiterlaser (1) im Laser-Betrieb ausgestrahlte Licht eine erste Wellenlänge (λ₁) oder eine zweite Wellenlänge (λ₂) hat, wobei letztere gleich der Wellenlänge (λ₂) des eingestrahlten Lichts ist.

2. Optische Einrichtung mit einem auf einem Substrat (2) monolithisch integrierten ersten Halbleiterlaser (1), der eine Kavität (41) mit einfach zusammenhängender Struktur besitzt, die sich oberhalb einer zur Grundfläche des Substrates (2) koplanaren Ebene erstreckt und verzweigt ist, und mit einer Lichtquelle (14) mit einstellbarer optischer Leistung (P_{E}), aus der in die Kavität (41) des ersten Halbleiterlasers (1) Licht einstrahlbar ist, wobei im Betriebszustand des Halbleiterlasers (1) der durch ihn fließende Betriebsstrom so bemessen ist, daß der Laser dadurch noch nicht im laseraktiven Zustand ist und daß durch Einstrahlung von Licht, dessen Wellenlänge (λ₂) unterhalb einer vorgegebenen maximalen Wellenlänge liegt, aus der Lichtquelle (14) der Halbleiterlaser (1) in den laseraktiven Zustand übergeht und kohärentes Licht mit einer bestimmten Wellenlänge (λ₁) emittiert, die länger ist als die Wellenlänge (λ₂) des eingestrahlten Lichts.

3. Optische Einrichtung nach Anspruch 1, bei der die Lichtquelle ein zweiter Halbleiterlaser (14) ist, der kohärentes Licht erzeugt.

4. Optische Einrichtung nach Anspruch 3, bei der der zweite Halbleiterlaser mit dem ersten Halbleiterlaser (1) auf dem Substrat (2) monolithisch integriert ist.

5. Verwendung der optischen Einrichtung nach einem der Ansprüche 1, 3 und 4, bei der ein verrauschtes Lichtsignal in den ersten Halbleiterlaser (1) eingestrahlt wird und bei der der Halbleiterlaser (1) in Abhängigkeit von der optischen Leistung (P_{E}) des eingestrahlten Lichtsignals ein Lichtsignal mit der ersten oder der zweiten Wellenlänge ausstrahlt (Fig. 3).

6. Verwendung der optischen Einrichtung nach einem der Ansprüche 1, 3 und 4, bei der ein Lichtsignal in den Halbleiterlaser eingestrahlt wird, dessen optische Leistung entweder ein erstes oder ein zweites Niveau hat und bei der dieses Lichtsignal in ein Lichtsignal umgewandelt wird, das entsprechend der optischen Leistung des eingestrahlten Lichtsignals entweder die erste oder die zweite Wellenlänge hat (Fig. 4).

7. Optische Einrichtung nach einem der Ansprüche 1, 3 und 4, bei der ein entweder nur für die erste oder nur für die zweite Wellenlänge durchlässiges optisches Filter vorhanden und im Weg des von dem ersten Halbleiterlaser (1) ausgestrahlten Lichtsignals angeordnet ist.

8. Verwendung der optischen Einrichtung nach einem der Ansprüche 1, und 7, bei der in den ersten Halbleiterlaser (1) ein Lichtsignal mit zeitlich variierender optischer Leistung (P_{E}) eingestrahlt wird, und bei der der erste Halbleiterlaser (1) ein Lichtsignal der ersten Wellenlänge (λ₁) erzeugt, wenn die optische Leistung (P_{E}) des Eingangs-Lichtsignals in einem ersten Leistungsbereich (L₁)) liegt, und mit der zweiten Wellenlänge (λ₂), wenn die optische Leistung (P_{E}) des Eingangs-Lichtsignals oberhalb des ersten Leistungsbereichs (L₁) liegt.

9. Optische Einrichtung nach Anspruch 2, mit einer zweiten Lichtquelle, die Licht mit einer Wellenlänge erzeugt, die ebenfalls unterhalb der vorgegebenen maximalen Wellenlänge liegt, wobei die erste und die zweite Lichtquelle durch jeweils ein optisches Übertragungsmittel an Enden verschiedener Zweige der verzweigten Kavität (41) des ersten Halbleiterlasers (1) angekoppelt sind.

10. Verwendung einer optischen Einrichtung nach Anspruch 9, zum Zusammenfassen zweier digital intensitätsmodulierter Lichtsignale zu einem optischen Multiplexsignal.

11. Verwendung der optischen Einrichtung nach Anspruch 9, bei der der durch den ersten Halbleiterlaser (1) fließende Betriebsstrom und die optischen Leistungen der von den beiden Lichtquellen in den Halbleiterlaser eingestrahlten Lichtsignale so bemessen sind, daß der erste Halbleiterlaser (1) dann kohärentes Licht mit der bestimmten Wellenlänge (λ₁) emittiert, wenn entweder in einen der beiden Zweige der verzweigten Kavität (41) oder gleichzeitig in beide Zweige ein Lichtsignal aus einer der beiden Lichtquellen bzw. aus jeweils einer der beiden Lichtquellen eingestrahlt wird, so daß der erste Halbleiterlaser (1) für die zwei einstrahlbaren Lichtsignale als optische ODER-Logikschaltung wirkt.

12. Verwendung der optischen Einrichtung nach Anspruch 9, bei der der durch den ersten Halbleiterlaser (1) fließende Betriebsstrom und die optischen Leistungen der aus den beiden Lichtquellen in ihn einstrahlbaren Lichtsignale so bemessen sind, daß der Halbleiterlaser (1) nur dann kohärentes Licht mit der bestimmten Wellenlänge (λ₁) emittiert, wenn aus beiden Lichtquellen jeweils ein Lichtsignal in die beiden Zweige der verzweigten Kavität (41) gleichzeitig eingestrahlt wird, so daß der erste Halbleiterlaser (1) für die beiden in ihn einstrahlbaren Lichtsignale als optische UND-Logikschaltung wirkt.

13. Verwendung der optischen Einrichtung nach Anspruch 2 als Impulsformer und Wellenlängenkonverter für ein digital intensitätsmoduliertes, verrauschtes Lichtsignal mit einer Wellenlänge (λ₂), die unterhalb der vorgegebenen maximalen Wellenlänge liegt, das in dem Halbleiterlaser (1) in ein Lichtsignal mit der bestimmten Wellenlänge (λ₁) umgewandelt wird.

14. Optische Einrichtung nach Anspruch 2 oder Anspruch 9, bei der an den Enden der Kavität (41) oder zwischen Teilbereichen (8, 9, 10, 11) der Kavität (41) jeweils mindestens ein Bereich vorhanden ist, der als sättigbarer Absorber dient.

## Claims

1. Optical device with a first semiconductor laser (1) integrated monolithically on a substrate (2), which first semiconductor laser (1) possesses a cavity (41) of single coherent structure which extends above a plane coplanar with the basal surface of the substrate (2) and is branched, and with a light source (14) with adjustable optical power (P_{E}) from which there is irradiatable into the cavity (41) of the first semiconductor laser (1) light by means of which the wavelength of coherent light signals radiated by the first semiconductor laser can be varied as a function of the optical power of the irradiated light, wherein the light irradiated into the semiconductor laser (1) by the light source (14) has a wavelength (λ₂) such that the light radiated by the semiconductor laser (1) when the laser is operational has as a function of its optical power (P_{E}) a first wavelength (λ₁) or a second wavelength (λ₂), wherein the latter is equal to the wavelength (λ₂) of the irradiated light.

2. Optical device with a first semiconductor laser (1) integrated monolithically on a substrate (2), which first semiconductor laser (1) possesses a cavity (41) of single coherent structure which extends above a plane coplanar with the basal surface of the substrate (2) and is branched, and with a light source (14) with adjustable optical power (P_{E}) from which light is irradiatable into the cavity (41) of the first semiconductor laser (1), wherein with the semiconductor laser (1) in the operating state the operating current flowing through it is so proportioned that the laser is thereby not yet in the laser-active state and that by the irradiation of light whose wavelength (λ₂) lies below a predetermined maximum wavelength the semiconductor laser (1) passes out of the light source (14) into the laser-active state and emits coherent light at a particular wavelength (λ₁) which is longer than the wavelength (λ₂) of the irradiated light.

3. Optical device according to claim 1, in which the light source is a second semiconductor laser (14) which generates coherent light.

4. Optical device according to claim 3, in which the second semiconductor laser is monolithically integrated with the first semiconductor laser (1) on the substrate (2).

5. Use of the optical device according to one of claims 1, 3 and 4, in which a noisy light signal is irradiated into the first semiconductor laser (1) and in which the semiconductor laser (1) radiates as a function of the optical power (P_{E}) of the irradiated light signal a light signal with the first or the second wavelength (Fig. 3).

6. Use of the optical device according to one of claims 1, 3 and 4, in which a light signal is irradiated into the semiconductor laser whose optical power has either a first or a second level and in which this light signal is converted into a light signal which according to the optical power of the irradiated light signal has either the first or the second wavelength (Fig. 4).

7. Optical device according to one of claims 1, 3 and 4, in which an optical filter permeable either only to the first or only to the second wavelength is provided and is arranged in the path of the light signal radiated by the first semiconductor laser (1).

8. Use of the optical device according to one of claims 1 and 7, in which there is irradiated into the first semiconductor laser (1) a light signal.with optical power (P_{E}) varying over time, and in which the first semiconductor laser (1) generates a light signal of the first wavelength (λ₁) if the optical power (P_{E}) of the input light signal lies in a first power range (L₁)), and with the second wavelength (λ₂) if the optical power (P_{E}) of the input light signal lies above the first power range (L₁).

9. Optical device according to claim 2, with a second light source which generates light with a wavelength which also lies below the predetermined maximum wavelength, wherein the first and the second light source are each coupled by an optical transmission means to ends of different branches of the branched cavity (41) of the first semiconductor laser (1).

10. Use of an optical device according to claim 9, for the combining of two digitally intensity-modulated light signals into an optical multiplex signal.

11. Use of the optical device according to claim 9, in which the operating current flowing through the first semiconductor laser (1) and the optical powers of the light signals irradiated into the semiconductor laser by the two light sources are so proportioned that the first semiconductor laser (1) emits coherent light with the particular wavelength (λ₁) if there is irradiated either into one of the two branches of the branched cavity (41) or simultaneously into both branches a light signal from one of the two light sources or from one in particular of the two light sources, so that the first semiconductor laser (1) acts as an optical OR-logic circuit for the two irradiated light signals.

12. Use of the optical device according to claim 9, in which the operating current flowing through the first semiconductor laser (1) and the optical powers of the light signals irradiatable into it from the two light sources are so proportioned that the semiconductor laser (1) emits coherent light with the particular wavelength (λ₁) only if a light signal is irradiated simultaneously from the two light sources in each of the two branches of the branched cavity (41), so that the first semiconductor laser (1) acts as an optical AND-logic circuit for the two light signals irradiated into it.

13. Use of the optical device according to claim 2 as a pulse former and wavelength converter for a digitally intensity-modulated, noisy light signal with a wavelength (λ₂) which lies below the predetermined maximum wavelength, which noisy light signal is converted into a light signal with the particular wavelength (λ₁) in the semiconductor laser (1).

14. Optical device according to claim 2 or claim 9, in which there exists at the ends of the cavity (41) or between sub-regions (8, 9, 10, 11) of the cavity (41) in each case at least one region which serves as a saturatable absorber.

## Revendications

1. Système optique doté d'un premier laser à semi-conducteur (1) intégré monolithique sur un substrat (2), lequel possède une cavité (41) ramifiée à structure cohérente simple située au-dessus d'une zone coplanaire par rapport à la surface de base du substrat (2) et d'une source lumineuse (14) à puissance optique (PE) réglable capable d'irradier de la lumière dans la cavité (41) du premier laser à semi-conducteur (1), ce qui permet de modifier la longueur d'onde des signaux lumineux cohérents émis par le premier laser à semi-conducteur en fonction de la puissance optique de la lumière irradiée, la lumière irradiée par la source lumineuse (14) dans le laser à semi-conducteur (1) ayant une longueur d'onde (λ 2) telle que, en fonction de sa puissance optique (PE), la lumière émise par le laser à semi-conducteur (1) en service laser a une première longueur d'onde (λ1) ou une deuxième longueur d'onde (λ2), cette dernière étant identique à la longueur d'onde (λ2) de la lumière irradiée.

2. Système optique doté d'un premier laser à semi-conducteur (1) intégré monolithique sur un substrat (2),lequel possède une cavité (41) ramifiée à structure cohérente simple située au-dessus d'une zone coplanaire par rapport à la surface de base du substrat (2) et d'une source lumineuse (14) à puissance optique (PE) réglable qui irradie de la lumière dans la cavité (41) du premier laser à semi-conducteur (1), le courant de service traversant le laser à semi-conducteur (1) en service étant dosé de telle sorte que le laser ne puisse pas encore être à l'état actif et que, par irradiation d'une lumière, dont la longueur d'onde (λ2) se situe en dessous d'une longueur d'onde maximale donnée, à partir de la source lumineuse (14), le laser à semi-conducteur (1) passe à l'état actif et qu'une lumière cohérente soit émise dont la longueur d'onde spécifique (λ1) est plus longue que la longueur d'onde (λ2) de la lumière irradiée.

3. Système optique selon la revendication 1, caractérisé en ce que la source lumineuse est un deuxième laser à semi-conducteur (14) générant une lumière cohérente.

4. Système optique selon la revendication 3, caractérisé en ce que le deuxième laser à semi-conducteur est intégré monolithiquement au premier laser à semi-conducteur (1) sur le substrat (2).

5. Utilisation du système optique selon l'une des revendications 1, 3 et 4, caractérisée en ce qu'un signal lumineux faible est émis en direction du premier laser à semi-conducteur (1) et en ce que le laser à semi-conducteur (1) émet, en fonction de la puissance optique (PE ) du signal lumineux émis, un signal lumineux ayant la première ou la deuxième longueur d'onde (Fig. 3).

6. Utilisation du système optique selon l'une des revendications 1, 3 et 4, caractérisée en ce qu'un signal lumineux est émis en direction du laser à semi-conducteur, la puissance optique de ce signal ayant un premier ou un deuxième niveau et en ce que le dit signal lumineux est converti en un signal lumineux qui, selon la puissance optique du signal lumineux émis, a la première ou la deuxième longueur d'onde (Fig. 4).

7. Système optique selon l'une des revendications 1, 3 et 4, caractérisé en ce qu'un filtre optique transparent existe soit uniquement pour la première soit uniquement pour la deuxième longueur d'onde et est disposé sur le chemin du signal lumineux émis par le premier laser à semi-conducteur (1).

8. Utilisation du système optique selon l'une des revendications 1 et 7, caractérisée en ce qu'un signal lumineux à puissance optique (PE ) variable dans le temps est émis en direction du premier laser à semi-conducteur (1) et en ce que le premier laser à semi-conducteur génère un signal lumineux ayant la première longueur d'onde (λ1) quand la puissance optique (PE) du signal lumineux d'entrée se situe dans une première plage de puissance (L1) et un signal lumineux ayant la deuxième longueur d'onde (λ2) quand la puissance optique (PE) du signal lumineux d'entrée se situe au-dessus de la première plage de puissance (L1).

9. Système optique selon la revendication 2 doté d'une deuxième source lumineuse générant une lumière dont la longueur d'onde se situe également en dessous de la longueur d'onde maximale donnée, les première et deuxième sources lumineuses étant respectivement couplées par un système de transmission optique aux extrémités des différents rameaux de la cavité ramifiée (41) du premier laser à semi-conducteur (1).

10. Utilisation d'un système optique selon la revendication 9, en vue de la réunion de deux signaux lumineux numériques à intensité modulée en un signal multiplex optique unique.

11. Utilisation du système optique selon la revendication 9, caractérisé en ce que le courant de service traversant le premier laser à semi-conducteur (1) et les puissances optiques des signaux lumineux émis par les deux sources lumineuses en direction du laser à semi-conducteur sont dosés de telle sorte que le premier laser à semi-conducteur (1) émette une lumière cohérente ayant la longueur d'onde spécifique (λ1) quand un signal lumineux provenant d'une des deux sources lumineuses ou respectivement d'une des deux sources lumineuses est émis en direction soit d'un des deux rameaux de la cavité (41) ramifiée ou des deux rameaux à la fois de telle sorte que le premier laser à semi-conducteur (1) agisse vis-à-vis des deux signaux lumineux émis comme circuit OU optique

12. Utiisation du système optique selon la revendication 9, caractérisé en ce que le courant de service traversant le premier laser à semi-conducteur (1) et les puissances optiques des signaux lumineux émis à partir des deux sources lumineuses en direction de celui-ci sont dosés de manière que le laser à semi-conducteur (1) émette une lumière cohérente ayant la longueur d'onde spécifique (λ 1) uniquement quand un signal lumineux est respectivement et simultanément émis à partir des deux sources lumineuses en direction des deux rameaux de la cavité (41) ramifiée de telle sorte que le premier laser à semi-conducteur (1) agisse vis-à-vis des deux signaux lumineux émis en sa direction comme circuit ET optique.

13. Utilisation du système optique selon la revendication 2 comme générateur d'impulsions et convertisseur de longueurs d'onde pour signal lumineux numérique faible à intensité modulée dont la longueur d'onde (λ2) est située au-dessous de la longueur d'onde maximale donnée et qui est converti dans le laser à semi-conducteur (1) en un signal lumineux ayant la longueur d'onde spécifique (λ1).

14. Système optique selon la revendication 2 ou 9, caractérisé en ce que, aux extrémités de la cavité (41, ou entre les différentes zones (8, 9, 10, 11) de la cavité (41), se trouve au moins une zone servant d'absorbeur saturable.
